(19) Europäisches Patentamt

European Patent Office

Office européen des brevets

(11) **EP 1 174 764 B1**

(12) **EUROPEAN PATENT SPECIFICATION**

(45) Date of publication and mention
of the grant of the patent:
**31.03.2004 Bulletin 2004/14**

(51) Int Cl.⁷: **G03F 1/14**

(21) Application number: **01306233.6**

(22) Date of filing: **19.07.2001**

(54) **Assist features for use in lithographic projection**

Hilfsmuster für lithographisches Belichtungsverfahren

Motifs auxiliaires pour exposition lithographique

(84) Designated Contracting States:
**DE FR GB IT NL**

(30) Priority: **21.07.2000 EP 00306237**
**01.11.2000 US 244657 P**

(43) Date of publication of application:
**23.01.2002 Bulletin 2002/04**

(73) Proprietors:
• **ASML Netherlands B.V.**
**5503 LA Veldhoven (NL)**
• **ASML Masktools B.V.**
**5503 LA Veldhoven (NL)**

(72) Inventors:
• **Baselmans, Johannes Jacobus Metheus**
**5688 GG Oirschot (NL)**
• **Schluter, Markus**
**5622 CM Eindhoven (NL)**
• **Flagello, Donis George**
**Arizona, AZ 85255 (US)**
• **Socha, Robert John**
**California, CA 95008 (US)**

(74) Representative: **Leeming, John Gerard**
**J.A. Kemp & Co.,**
**14 South Square,**
**Gray's Inn**
**London WC1R 5JJ (GB)**

(56) References cited:
**US-A- 6 074 787**

• **KROYAN A ET AL: "Effects of sub-resolution assist features on depth of focus and uniformity of contact windows for 193 mu m lithography" OPTICAL MICROLITHOGRAPHY XII, SANTA CLARA, CA, USA, 17-19 MARCH 1999, vol. 3679, pt.1-2, pages 630-638, XP001083867 Proceedings of the SPIE - The International Society for Optical Engineering, 1999, SPIE-Int. Soc. Opt. Eng, USA ISSN: 0277-786X**

**Description**

The present invention relates to masks, having assist features, for use in methods of manufacturing devices using a lithographic projection apparatus comprising:

an illumination system for supplying a projection beam of radiation;
a first object table provided with a first object holder for holding a mask;
a second object table provided with a second object holder for holding a substrate; and
a projection system for imaging an irradiated portion of the mask onto a target portion of the substrate; a typical method comprising the steps of:

providing a mask bearing a pattern to said first object table;
providing a substrate having a radiation-sensitive layer to said second object table; and
imaging said irradiated portions of the mask onto said target portions of the substrate.

For the sake of simplicity, the projection system may hereinafter be referred to as the "lens"; however, this term should be broadly interpreted as encompassing various types of projection system, including refractive optics, reflective optics, catadioptric systems, and charged particle optics, for example. The illumination system may also include elements operating according to any of these principles for directing, shaping or controlling the projection beam, and such elements may also be referred to below, collectively or singularly, as a "lens". In addition, the first and second object tables may be referred to as the "mask table" and the "substrate table", respectively.
In the present document, the terms "radiation" and "beam" are used to encompass all types of electromagnetic radiation, including, but not limited to, ultraviolet radiation (e.g. at a wavelength of 365nm, 248nm, 193nm, 157nm or 126nm) and extreme ultraviolet radiation (EUV); in principle, these terms also encompass X-rays, electrons and ions. Also herein, the invention is described using a reference system of orthogonal X, Y and Z directions, and rotation about an axis parallel to the $I$ direction is denoted R$i$. Further, unless the context otherwise requires, the term "vertical" (Z) used herein is intended to refer to the direction normal to the substrate or mask surface or parallel to the optical axis of an optical system, rather than implying any particular orientation of the apparatus. Similarly, the term "horizontal" refers to a direction parallel to the substrate or mask surface or perpendicular to the optical axis, and thus normal to the "vertical" direction.
Lithographic projection apparatus can be used, for example, in the manufacture of integrated circuits (ICs). In such a case, the mask (reticle) may contain a circuit pattern corresponding to an individual layer of the IC, and this pattern can be imaged onto a target portion or exposure area (comprising one or more dies) on a substrate (silicon wafer) which has been coated with a layer of radiation sensitive material (resist). In general, a single wafer will contain a whole network of adjacent target portions that are successively irradiated via the reticle, one at a time. In one type of lithographic projection apparatus, each target portion is irradiated by exposing the entire mask pattern onto the target portion in one go; such an apparatus is commonly referred to as a wafer stepper. In an alternative apparatus C which is commonly referred to as a step-and-scan apparatus C each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned from International Patent Application WO97/33205, for example.
In general, lithographic apparatus contain a single mask table and a single substrate table. However, machines are becoming available in which there are at least two independently moveable substrate tables; see, for example, the multi-stage apparatus described in International Patent Applications WO98/28665 and WO98/40791. The basic operating principle behind such multi-stage apparatus is that, while a first substrate table is at the exposure position underneath the projection system for exposure of a first substrate located on that table, a second substrate table can run to a loading position, discharge a previously exposed substrate, pick up a new substrate, perform some initial metrology steps on the new substrate and then stand ready to transfer the new substrate to the exposure position underneath the projection system as soon as exposure of the first substrate is completed; the cycle then repeat; the cycle then repeats. In this manner it is possible to increase substantially the machine throughput, which in turn improves the cost of ownership of the machine. It should be understood that the same principle could be used with just one substrate table which is moved between exposure and loading positions.
It is known to provide so-called "assist features" in masks to improve the image projected onto the resist and ultimately the developed device. Assist features are features that are not intended to appear in the pattern developed in the resist but are provided in the mask to take advantage of diffraction effects so that the developed image more closely resembles the circuit pattern. Assist features are generally "sub-resolution" meaning that they are smaller in at least one dimension than the smallest feature in the mask that will actually be resolved on the wafer. Assist features may have dimensions defined as fractions of the "critical dimension", which is the smallest width of a feature or smallest separation between features in the mask and is often the resolution limit of the lithographic projection apparatus with which the mask is to be used. Note though that because the mask pattern is generally projected with a magnification of less than 1, e.g. 1/4 or 1/5, the assist feature on the mask may have a physical dimension larger than the smallest feature on the wafer. Two types of assist features are known. Scattering bars are lines with a sub-resolution width placed on one or both sides of an isolated conductor to mimic proximity effects that occur in densely packed regions of a pattern. Serifs are additional areas of various shapes placed at the corners and ends of conductor lines, or the corners of rectangular features, to make the end of the line, or the corner, more nearly square or round, as desired (note in this context that assist features commonly referred to as "hammerheads" are being regarded as a form of serif). Further information on the use of scattering bars and serifs can be found in US 5,242, 770 and US 5,707,765, for example. US 6,074,787 discloses a procedure for designing assist features for non-repetitive and complex patterns. Contact holes, or vias, in integrated circuits cause particular problems in imaging. Because the contact holes often have to be formed through numerous or relatively thick process layers previously formed on the wafer, they must be patterned into a relatively thick layer of photoresist, requiring an increased depth of focus in the aerial image of the mask pattern.

An object of the present invention is to provide an improved mask for better imaging of regularly- or irregularly-spaced dense features, such as contact holes, as well as a method of making such a mask and a method of manufacturing devices using the improved mask.

According to the present invention there is provided a mask for use in a lithographic projection apparatus, the mask comprising a plurality of isolated areas that contrast with the background and represent features to be printed in manufacture of a device, said isolated areas arranged generally in an array; characterized by:

a plurality of assist features smaller than said isolated areas and positioned so as to make said array more symmetric.

The assist features, by reducing asymmetry in the array, tend to reduce aberrations in the aerial image and are ideally located so as to reduce all asymmetric aberrations, caused by odd aberrations such as 3-wave and coma. In an array that already has some degree(s) of symmetry, the assist features may add additional degrees of symmetry or may make a unit (primitive) cell more symmetric within itself. In this way, the invention can provide improvements in imaging symmetry that are largely independent of exposure device and illumination or projection settings. In many cases, the isolated features can be seen as occupying lattice points of a regular array (though the isolated features may be displaced slightly from the points of an ideal lattice) but with one or more of the points of the unit, or primitive, cell being vacant. In this case, the assist features are placed at at least some of the vacant lattice points.

An array of features in a mask which is itself regular, e.g. having one or more degrees of rotational or reflective symmetry, is inevitably finite and hence lacks translation symmetry; the unit cells at the edges of the array are not exactly equivalent to those in the middle as they have fewer neighbors. Thus, assist features according to the invention may be placed around the outside of an array to form pseudo-neighbors for the outermost features in the array. Of course, multiple assist features of different locations may be used in an array with, for example, assist features placed within the array to make the array more rotationally or reflectively symmetric and outside the array to make the surroundings of the outermost features more similar to the inner features.

The assist features should be sufficiently small in at least one dimension so as not to appear in the developed pattern of the resist, though they may be detectable in the aerial image and may partially expose the photo- (energy sensitive) resist. The assist features are therefore generally smaller than the critical dimension of the mask pattern and the resolution limit of the lithographic apparatus with which the mask is to be used.

The isolated areas may for example represent contact holes to be formed in a DRAM array. The isolated areas and assist features may be transparent areas on a relatively opaque background or vice versa. In a reflective mask, the isolated areas and assist features will have a different reflectivity than the background. In a phase shift mask, the isolated areas and assist features may introduce a different phase shift and/or a different attenuation than the background. The assist features need not have the same "tone" as the isolated areas.

According to another aspect of the invention there is provided a method of making a mask for use in a lithographic projection apparatus, the method comprising the step of defining a plurality of isolated areas that contrast with the background and represent features to be printed in manufacture of a device, said isolated areas arranged generally in an array; characterized by the further step of:

defining a plurality of assist features smaller than said isolated areas and positioned so as to make said array more symmetric.

The positions, shapes and sizes of the assist features may be determined by calculating aberrations in the wavefront that would be produced by the pattern without them and then determining positions, etc., for the assist features that reduce the predicted aberrations, especially 3 wave and 1 wave (comatic) aberrations.

According to a further aspect of the present invention there is provided a method of manufacturing a device using a lithographic projection apparatus comprising:

an illumination system for supplying a projection beam of radiation;
a first object table provided with a first object holder for holding a mask;
a second object table provided with a second object holder for holding a substrate; and
a projection system for imaging an irradiated portion of the mask onto a target portion of the substrate; the method comprising the steps of:

providing a mask bearing a pattern to said first object table, said mask comprising a plurality of isolated areas that contrast with the background and represent features to be printed in manufacture of a device, said isolated areas arranged generally in an array;
providing a substrate having a radiation-sensitive layer to said second object table; and
imaging said irradiated portions of the mask onto said target portions of the substrate; characterized in that: said mask is provided with a plurality of assist features smaller than said isolated areas and positioned so as to make said array more symmetric.

In a manufacturing process using a lithographic projection apparatus according to the invention a pattern in a mask is imaged onto a substrate which is at least partially covered by a layer of radiation sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices (dies) will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion" or "exposure area", respectively.

Although this text has concentrated on lithographic apparatus and methods whereby a mask is used to pattern the radiation beam entering the projection system, it should be noted that the invention presented here should be seen in the broader context of lithographic apparatus and methods employing generic "patterning means" to pattern the said radiation beam. The term "patterning means" as here employed refers broadly to means that can be used to endow an incoming radiation beam with a patterned cross-section, corresponding to a pattern that is to be created in a target portion of the substrate; the term "light valve" has also been used in this context. Generally, the said pattern will correspond to a particular functional layer in a'device being created in the target portion, such as an integrated circuit or other device. Besides a mask on a mask table, such patterning means include the following exemplary embodiments:

- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from United States Patents US 5,296,891 and US 5,523,193.
- A programmable LCD array. An example of such a construction is given in United States Patent US 5,229,872.

The text and Claims of this document should be interpreted as encompassing such generic patterning means, as alternatives for a mask.

The present invention will be described below with reference to exemplary embodiments and the accompanying schematic drawings, in which:

Figure 1 depicts a lithographic projection apparatus with which embodiments of the invention can be used;
Figure 2 depicts a part of a mask pattern for printing contact holes in the manufacture of a dynamic random access memory (DRAM);
Figure 3 depicts a part of a mask pattern according to a first embodiment of the present invention for printing contact holes in a DRAM;
Figure 4 is a graph of intensities of part of the aerial images produced by the mask patterns of Figures 2 and 3;
Figure 5 depicts a part of an alternative mask pattern for printing contact holes;
Figure 6 depicts a part of a mask pattern according to a second embodiment of the invention;
Figure 7 is a graph of intensities of part of the aerial images produced by the mask patterns of Figures 5 and 6;
Figure 8 depicts part of a mask pattern for printing rectangular features;
Figure 9 depicts part of a mask pattern according to a third embodiment of the invention for printing rectangular features;
Figure 10 is a contour plot of intensities of a part of the aerial images produced by the mask patterns of Figures 8 and 9; and
Figure 11 depicts part of a mask pattern according to a fourth embodiment of the invention.

In the drawings, like references indicate like parts.

Lithographic Projection Apparatus

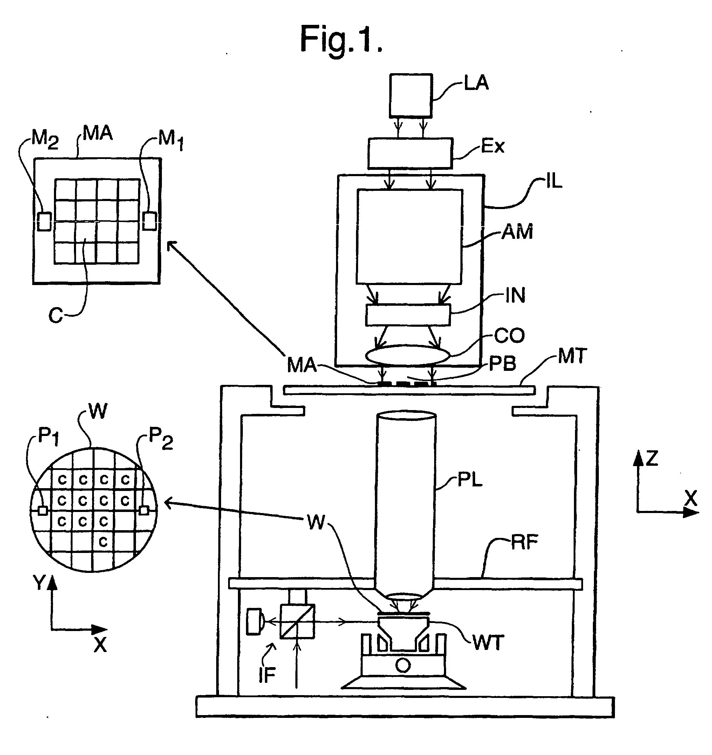

Figure 1 schematically depicts a lithographic projection apparatus that may be used with the invention. The apparatus comprises:

a radiation system Ex, IL, for supplying a projection beam PB of radiation (*e.g.* UV or EUV radiation). In this particular case, the radiation system also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
a projection system ("lens") PL (*e.g.* a refractive, catadioptric or catoptric system) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array or LCD as referred to above.

The source LA (*e.g.* a lamp, laser or discharge plasma chamber) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

- In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

- In scan mode, essentially the same scenario applies, except that a given target portion C is not exposed in a single "flash". Instead, the mask table MT is movable in a given direction (the so-called "scan direction", *e.g.* the *y* direction) with a speed $v$, so that the projection beam PB is caused to scan over a mask image; concurrently, the substrate table WT is simultaneously moved in the same or opposite direction at a speed $V = Mv$, in *which M* is the magnification of the lens PL (typically, $M = 1/4$ or $1/5$). In this manner, a relatively large target portion C can be exposed, without having to compromise on resolution.

Embodiment 1

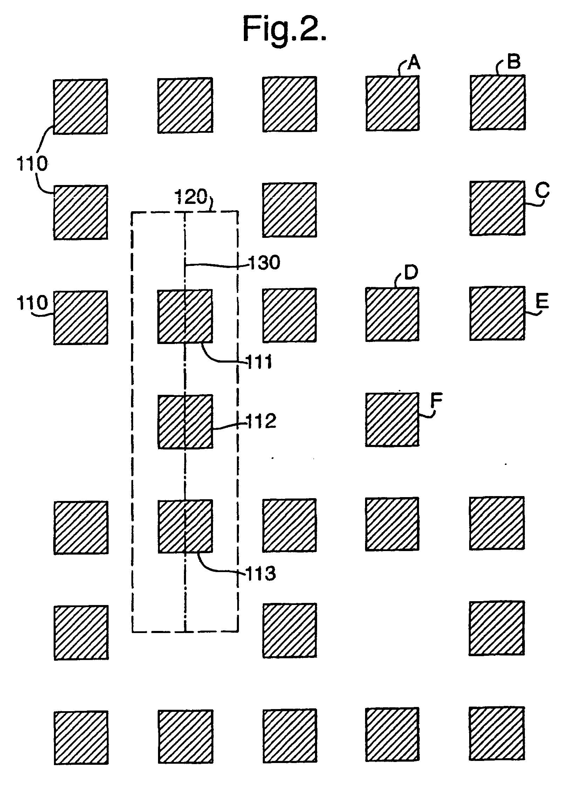

Figure 2 shows part of a conventional 6% attenuated phase shift mask pattern which may be used in the lithographic projection apparatus described above for forming contact holes (vias) in a dynamic random access memory (DRAM) device. The mask pattern has an array of transparent areas 110, which let through the exposure radiation to expose the resist in the areas where contact holes are to be formed, in a substantially opaque field. It will be seen that the transparent areas are arranged such that a group of three, referenced 111, 112, 113, repeats regularly. The contact holes are 0.2μm square with the spacing between contacts 0.2μm. A reference area 120 of 0.4 x 1.6μm$^2$ is also shown.

The inventors have discovered that these contact holes do not image correctly, being misshapen and displaced from their nominal positions.

According to the present invention, assist features are added to the mask pattern to make the array of features more nearly symmetric. Suitable positions and dimensions for the assist features are determined empirically by consideration of the Zernike coefficients representing wavefront aberrations in the image that will be produced from the pattern and postulated assist features.

The wavefront aberrations can be written as a series according to their angular form:

$$W(r, \theta) = \sum_m R_m(r) \cos(m\theta) + R'_m(r) \sin(m\theta) \ .$$

where $r$ and $\theta$ are radial and angular co-ordinates, respectively, (r is normalized) and $m$ is an index indicating the contribution of the $m$th aberration. $R$ and $R'$ are functions of $r$.

The aberration can also be expressed in terms of the Zernike expansion:

$$W = Zif_i(r,\theta) + Zjf_j(r,\theta) + Zkf_k(r,\theta) + ...$$

where each Z is the Zernike coefficient and each $f$ is the corresponding Zernike polynomial. The functions $f$ take the form of the product of a polynomial in $r$ and sin or cos of $m\theta$. For example, the comatic aberration ($m$=1) can be represented by a Zernike series in Z7, Z8, Z14, Z15, Z23, Z24, Z34, Z35 etc., and, for example, the function associated with the Z7 coefficient [$f_7(r,\theta)$ in the notation above] is:

$$(3r^3 - 2r)\cos(\theta)$$

The Zernike expansion for the lower-order aberrations is summarized in Table I below.

In particular, the inventors have determined that substantial improvements can be achieved by arranging assist features to manipulate the odd aberrations (odd $m$-numbers), especially the Z10 (3 wave) coefficient. Improvements can also be obtained by arranging assist features to reduce coma (1 wave) aberrations in the aerial image. The positions, shapes and sizes of assist features can be determined using known computational techniques, such as the program known as "Solid C", a commercial software package supplied by the company Sigma-C GmbH in Germany, for simulating and modeling optical lithography. Other suitable software packages, such as one known as "Prolith", may alternatively be used.

Table I

| Aberration | | Low-order Zernikes | | Higher orders |
|---|---|---|---|---|
| m | Name | Function | Term | Term |
| 0 | spherical | $6r^4 - 6r^2 + 1$ | Z9 | Z16, Z25, Z36, Z37 |
| 1 | X-coma | $(3r^3-2r) \cos \theta$ | Z7 | Z14, Z23, Z34 |
| 1 | Y-coma | $(3r^3 - 2r) \sin \theta$ | Z8 | Z15, Z24, Z35 |
| 2 | astigmatism | $r^2 \cos 2\theta$ | Z5 | Z12, Z21, Z32 |
| 2 | 45° astigmatism | $r^2 \sin 2\theta$ | Z6 | Z13, Z22, Z33 |
| 3 | X- three-point | $r^3 \cos 3\theta$ | Z10 | Z19, Z30 |
| 3 | Y- three-point | $r^3 \sin 3\theta$ | Z11 | Z20, Z31 |

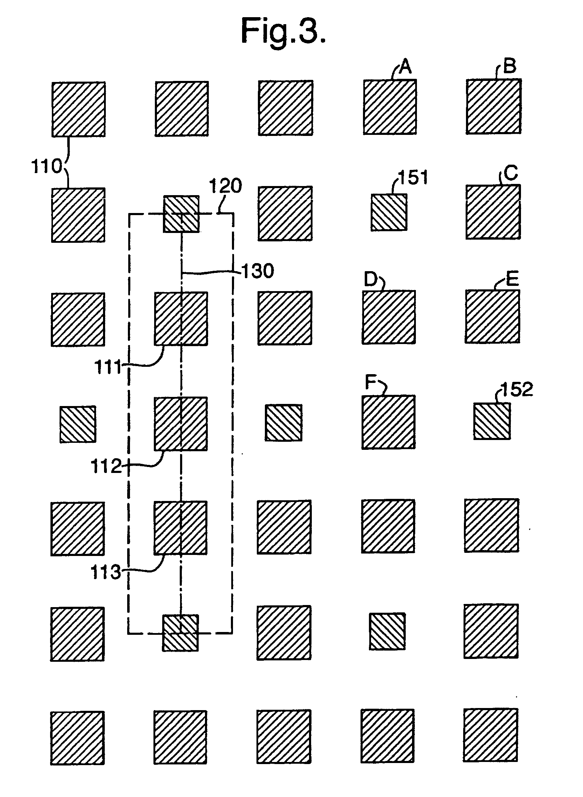

In the DRAM example, improvements are achieved by regarding the six repeated transparent areas (see Figure 3) as two pairs of triplets A, B, C and D, E, F with each member of the triplet occupying one of the four corners of a square (in this example) unit cell. According to the invention, assist features 151, 152 are placed at the fourth corners and comprise a transparent square of a size too small to be printed in the developed pattern. The squares can be 0.12μm each side, for example. Note that the assist features may be visible in the aerial image and partly expose the resist but be washed out in development of the resist.

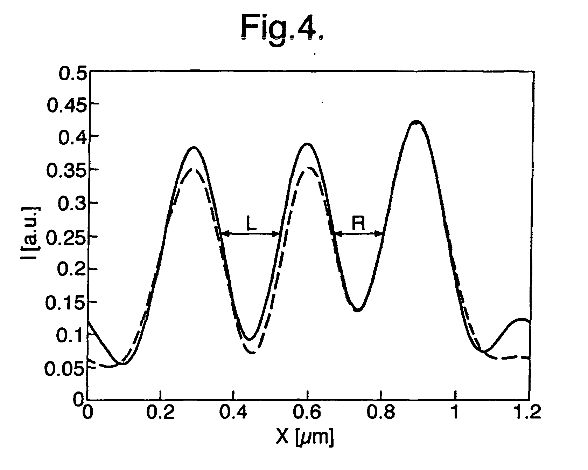

The efficacy of the present invention is seen in Figure 4 which is a graph of intensity in the aerial images produced by the mask patterns of Figures 2 and 3 corresponding to the line 130. In Figure 4 the solid line represents the intensity of the aerial images produced by the mask pattern according to the invention (Figure 3) and the dashed line represents the intensity of the aerial image produced by the conventional mask pattern (Figure 2). The asymmetry of printing can be represented by the distances L and R shown in Figure 4; these represent the distances between the peaks which will form the contact holes, measured at the resist threshold, chosen as 0.25 in the arbitrary units of the graph of Figure 4. It can be seen that the distance L is reduced with the invention so that the asymmetry represented by the difference L - R is also reduced.

Embodiment 2

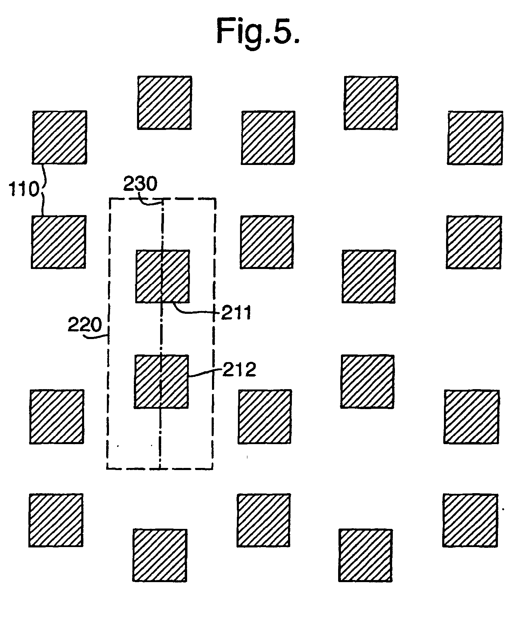

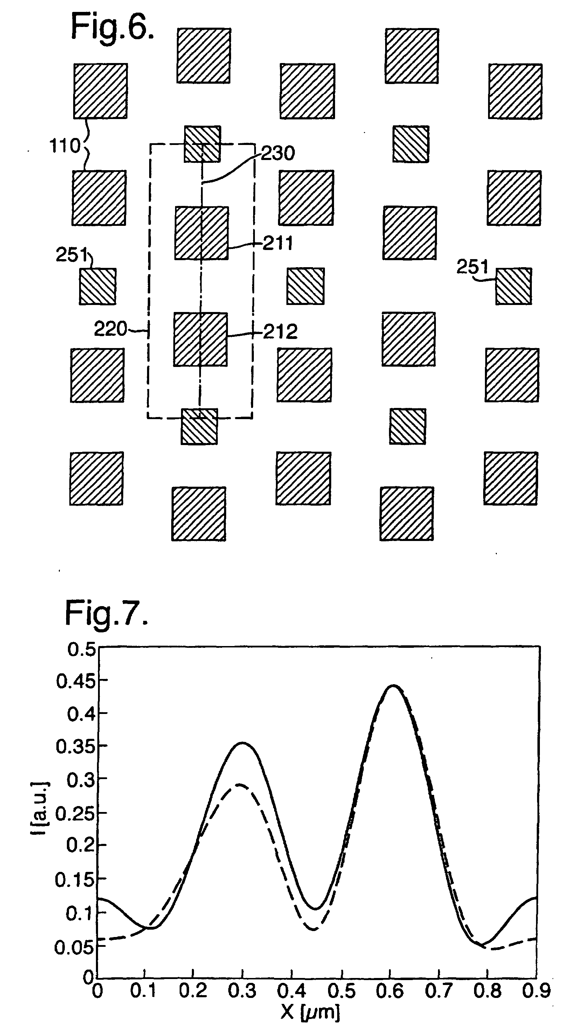

Figure 5 shows an alternative arrangement of contact holes 110. In this arrangement a pair of contact holes 211, 212 repeats to form a honeycomb structure. The contact holes may be 0.2μm square with a spacing between adjacent contacts of 0.2μm. Also shown is a reference area 220 of 0.4 x 0.9μm². According to the invention, the symmetry of this mask pattern is improved, as shown in Figure 6, by adding an additional assist feature 251 at the center of each honeycomb cell. The assist features 251 may be square of side 0.12μm, for example.

The improvement provided by the present invention in the second embodiment can be seen in Figure 7 which is a graph of intensities of the aerial images produced by the mask patterns of Figures 5 and 6 along the line 230. As with Figure 4, the solid line represents the intensity of the image produced by the mask pattern according to the invention (Figure 6) and the dashed line that of the conventional pattern (Figure 5). It will clearly be seen that the aerial image produced by the pattern according to the invention is less asymmetric.

Embodiment 3

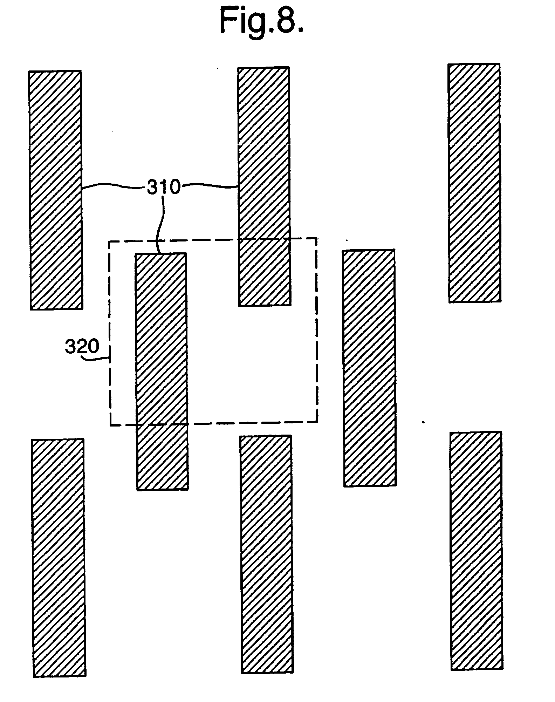

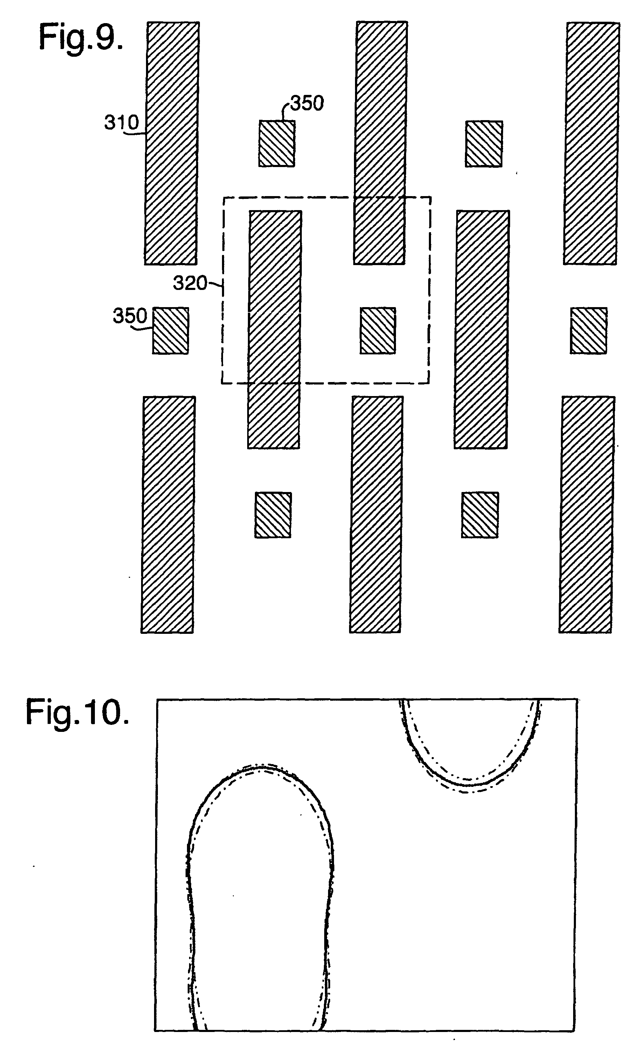

Figure 8 shows a conventional "brick wall" pattern of rectangles arranged in a staggered array. The rectangles are 0.2 x 0.5μm² with a spacing between adjacent rectangles of 0.2μm. The reference area 320 is 0.8 x 0.6μm². As shown in Figure 9, according to the invention, assist features 350 are placed between the rectangles 310. The assist features may again be 0.12μm on each side, for example.

Figure 10 is a contour plot at a 0.25 (arbitrary units) intensity threshold of the aerial image produced by the unit cell 320. The finely-dashed line represents the image produced by the present invention (Figure 9) whilst the single-chain line represents that produced by the conventional mask pattern (Figure 8). The double-chain line represents an ideal aerial image of the mask pattern with no 3 wave aberration. It will clearly be seen that the image provided by the present invention is closer to the ideal.

Embodiment 4

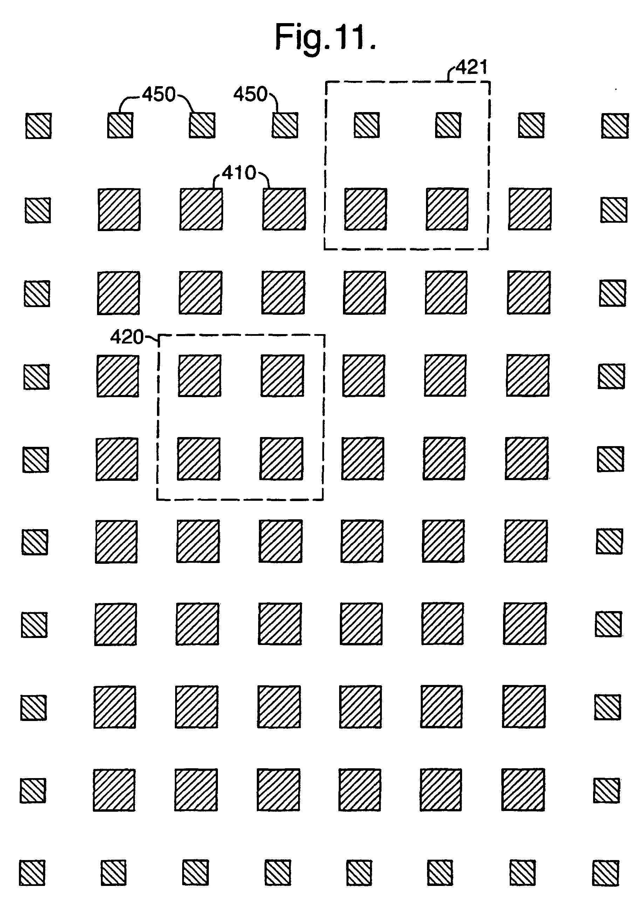

Figure 11 shows a mask pattern according to a fourth embodiment of the invention. This array comprises a regular rectangular array of features, e.g. contact holes 410. This array in itself is extremely regular and has a high degree of internal symmetry. However, by comparing the features within cell 420 with those within cell 421, it will be seen that there is a difference. The features 410 within cell 420 have neighbors on all sides whereas the features 410 in cell 421 have no neighbors outside them. Thus, according to the invention, assist features 450 are provided outside the array of features 410 to provide pseudo-neighbors for the features at the edge of the regular array. Thus, cell 421 becomes more similar to cell 420. Accordingly, the assist features improve the translational symmetry of the array in that the viewpoint from a printing feature 410 at the edge of the array is made more similar to the viewpoint from a printing feature 410 in the middle of the array.

The sizes of the printing features 410 and assist features 450 may be similar to those of embodiments 1 to 3 and modified as desired for a specific use of the invention. Where the printing features forming the array are not square, the assist features may also be non-square but again sufficiently small so as to not print. Assist features around the outside of an array may of course be used in conjunction with assist features within the array itself. Further, where the image of a given assist feature is affected by features further away than its nearest neighbors, additional rows of assist features may be provided as necessary. In general, it would be preferable to provide assist features around all sides of the array of printing features but the presence of other features near the array may make the provision of assist features around the entire periphery of the array unnecessary and/or impractical. Whilst in Figure 11 the assist features are shown spaced from the array by a distance equal to the array pitch, this distance may of course be varied to alter the effect of the assist features as desired.

Whilst we have described above specific embodiments of the invention it will be appreciated that the invention may be practiced otherwise than as described. The description is not intended to limit the invention. It should be explicitly noted that the present invention can be applied to any mask pattern having an (asymmetric) array or group of features. It should also be noted that the invention is applicable where the array comprises only part of the mask pattern, for example in the manufacture of system-on-chip devices combining memory and logic or processors on a single device.

**Claims**

1.  A mask for use in a lithographic projection apparatus, the mask comprising a plurality of isolated areas (110) that contrast with the background and represent features to be printed in manufacture of a device, said isolated areas arranged generally in an array; **characterised by**:

    a plurality of assist features (151) smaller than said isolated areas and positioned so as to make said array more symmetric.

2.  A mask according to claim 1 wherein said isolated areas (110) are arrayed in groups defining a unit cell (120) and said assist features are positioned so as to make said unit cell more symmetric.

3.  A mask according to claim 2 wherein said isolated areas (110) are positioned at or near some of the points of one or more regular unit cells (120) and said assist features (151) are positioned at points of the regular unit cell(s) not occupied by said isolated areas.

4.  A mask according to claim 3 wherein said isolated areas (A, B, C) are positioned at three of the corners of a rectangular unit cell and said assist features (151) are positioned at the fourth corner.

5.  A mask according to claim 1, 2, 3 or 4 wherein said assist features (151) are positioned so as to reduce the effect of at least one odd aberration in the wavefront produced by said mask pattern when illuminated by exposure radiation in said lithographic projection apparatus.

6.  A mask according to any one of claims 1 to 5 wherein said assist features (450) are positioned along at least part of the edge of said array so as to make the surroundings of features (410) at or near the edge of the array more similar to the surroundings of features (420) in the interior of the array.

7.  A mask according to any one of the preceding claims wherein said assist features (151) are positioned so as to reduce the effect of 3 wave and/or comatic (1 wave) aberration in the wavefront produced by said mask pattern when illuminated by exposure radiation in said lithographic projection apparatus.

8. A mask according to any one of the preceding claims wherein said assist features (151) have the same contrast to the background of said mask as said isolated areas.

9. A mask according to any one of the preceding claims wherein said isolated features (110) are more transparent to the exposure radiation of said lithographic projection apparatus than said background.

10. A mask according to any one of claims 1 to 8 wherein said isolated features (110) are more reflective of the exposure radiation of said lithographic projection apparatus than said background.

11. A mask according to any one of claims 1 to 8 wherein said isolated features (151) impart a different phase shift than said background.

12. A mask according to any one of the preceding claims wherein said assist features (151) are smaller than a critical dimension of said mask.

13. A mask according to claim 12 wherein said assist features (151) are smaller than a resolution limit of said lithographic projection apparatus.

14. A method of making a mask for use in a lithographic projection apparatus, the method comprising the step of defining a plurality of isolated areas (110) that contrast with the background and represent features to be printed in the manufacture of a device, said isolated areas arranged generally in an array; **characterised by** the further step of:

   defining a plurality of assist features (151) smaller than said isolated areas (110) and positioned so as to make said array more symmetric.

15. A method according to claim 14 comprising the further steps of:

   determining wavefront aberrations in an aerial image that would be produced in said lithographic apparatus by the pattern of said isolated areas (110); and
   determining positions, shapes and sizes for said plurality of assist features (151) so as to reduce aberrations in said aerial image.

16. A method according to claim 15 wherein said positions for said plurality of assist features (151) are determined so as to reduce 3 wave and/or 1 wave (comatic) aberrations.

17. A method of manufacturing a device using a lithographic projection apparatus comprising:

   an illumination system (IL) for supplying a projection beam of radiation;
   A first object table (MT) provided with a first object holder for holding a mask;
   a second object table (WT) provided with a second object holder for holding a substrate; and
   a projection system (PL) for imaging an irradiated portion of the mask onto a target portion of the substrate;
   the method comprising the steps of:

      providing a mask (M) bearing pattern to said first object table, said mask comprising a plurality of isolated areas (110) that contrast with the background and represent features to be printed in the manufacture of a device, said isolated areas arranged generally in an array;
      providing a substrate (W) having a radiation sensitive layer to said second object table; and
      imaging said irradiated portions of the mask (M) onto said target portions of the substrate (W); **characterised in that**:

         said mask is provided with a plurality of assist features (151) smaller than said isolated areas (110) and positioned so as to make said array more symmetric.

18. A method according to claim 16 wherein said device includes a memory array, especially a dynamic random access memory array.

19. A method according to claim 17 or 18 wherein said assist features (151) have a largest dimension of less than 50% of the wavelength of said projection beam, preferably in the range of from 30 to 40% of the wavelength of said projection beam.

**Patentansprüche**

1. Maske zum Gebrauch in einem lithographischen Projektionsapparat, wobei die Maske eine Vielzahl von isolierten Bereichen (110) umfasst, die mit dem Hintergrund kontrastieren und Merkmale zum Drucken bei der Herstellung einer Vorrichtung repräsentieren, wobei die isolierten Bereiche allgemein in einem Gitter angeordnet sind; **gekennzeichnet durch**:

   eine Vielzahl von Hilfsmerkmalen (145), die kleiner sind als die isolierten Bereiche und die so angeordnet sind, dass sie das Gitter symmetrischer machen.

2. Maske nach Anspruch 1, bei der die isolierten Bereiche (110) in Gruppen angeordnet sind, die eine Einheitszelle (120) definieren, und die Hilfsmerkmale so angeordnet sind, dass sie die Einheitszelle symmetrischer machen.

3. Maske nach Anspruch 2, bei der die isolierten Bereiche (110) an oder nahe einiger Punkte einer oder mehrerer regulärer Einheitszellen (120) angeordnet sind und die Hilfsmerkmale (151) an Punkten der regulären Einheitszelle (n) angeordnet sind, die nicht durch die isolierten Bereiche besetzt sind.

4. Maske nach Anspruch 3, bei der die isolierten Bereiche (A, B, C) an drei der Ecken einer rechteckigen Einheitszelle angeordnet sind und die Hilfsmerkmale (151) an der vierten Ecke angeordnet sind.

5. Maske nach einem der Ansprüche 1, 2, 3 oder 4, bei der die Hilfsmerkmale (151) so positioniert sind, dass sie den Effekt wenigstens einer ungeraden Aberration in der Wellenfront reduzieren, die durch das Maskenbild erzeugt wird, wenn es durch Belichtung in dem lithographischen Projektionsapparat beleuchtet wird.

6. Maske nach einem der Ansprüche 1 bis 5, bei der die Hilfsmerkmale (450) entlang wenigstens eines Teils des Randes des Gitters angeordnet sind, um die Umgebung von Merkmalen (410) an oder nahe dem Rand des Gitters der Umgebung von Merkmalen (420) im Inneren des Gitters ähnlicher zu machen.

7. Maske nach einem der vorangehenden Ansprüche, bei der die Hilfsmerkmale (151) so angeordnet sind, dass sie den Effekt einer Drei-Wellen- und/oder komatischen (Ein-Wellen-) Aberration in der Wellenfront reduzieren, die durch das Maskenbild erzeugt wird, wenn dieses durch Belichtungsstrahlung in dem lithographischen Projektionsapparat beleuchtet wird.

8. Maske nach einem der vorangehenden Ansprüche, bei der die Hilfsmerkmale (151) den gleichen Kontrast gegenüber dem Hintergrund der Maske aufweisen wie die isolierten Bereiche.

9. Maske nach einem der vorhergehenden Ansprüche, bei der die isolierten Bereiche (110) für die Belichtungsstrahlung des lithographischen Projektionsapparates transparenter sind als der Hintergrund.

10. Maske nach einem der Ansprüche 1 bis 8, bei der die isolierten Merkmale (110) die Belichtungsstrahlung des lithographischen Projektionsapparates stärker reflektieren als der Hintergrund.

11. Maske nach einem der Ansprüche 1 bis 6, bei der die isolierten Merkmale (151) eine andere Phasenverschiebung verursachen als der Hintergrund.

12. Maske nach einem der vorangehenden Ansprüche, bei der die Hilfsmerkmale (151) kleiner sind als die kritische Dimension der Maske.

13. Maske nach Anspruch 12, bei der die Hilfsmerkmale (151) kleiner sind als die Auflösungsgrenze des lithographischen Projektionsapparats.

14. Verfahren zum Herstellen einer Maske zum Gebrauch in einem lithographischen Projektionsapparats, wobei das Verfahren den Schritt eines Definierens einer Vielzahl isolierter Bereiche (110) umfasst, die mit dem Hintergrund kontrastieren und Merkmale zum Drucken bei der Herstellung einer Vorrichtung repräsentieren, wobei die isolierten Bereiche allgemein in einem Gitter angeordnet sind; **dadurch gekennzeichnet, dass** es als weiteren Schritt umfasst:

Definieren einer Vielzahl von Hilfsmerkmalen (151), die kleiner sind als die isolierten Bereiche (110) und so positioniert sind, dass sie das Gitter symmetrischer machen.

**15.** Verfahren nach Anspruch 14, das als weiteren Schritt umfasst:

Bestimmen von Wellenfrontaberrationen in einem Hologramm, das in dem lithographischen Apparat durch das Muster der isolierten Bereiche (110) erzeugt würde; und
Bestimmen von Positionen, Formen und Größen für die Vielzahl der Hilfsmerkmale (151), um Aberrationen in dem Hologramm zu reduzieren.

**16.** Verfahren nach Anspruch 15, bei dem die Positionen für die Vielzahl von Hilfsmerkmalen (151) so bestimmt werden, dass sie Drei-Wellen- und/oder Ein-Wellen-(komatische) Aberrationen reduzieren.

**17.** Verfahren zum Herstellen einer Vorrichtung mit einem lithographischen Projektionsapparat, der umfasst:

ein Belichtungssystem (IL) zum Bereitstellen eines Projektionsstrahls;
einen ersten Objekttisch (MT) mit einem ersten Objekthalter zum Halten einer Maske;
einen zweiten Objekttisch (WT) mit einem zweiten Objekthalter zum Halten eines Substrats; und
ein Projektionssystem (PL) zum Abbilden eines belichteten Bereichs der Maske auf einen Zielbereich des Substrats;

wobei das Verfahren die Schritte umfasst:

Bereitstellen einer Maske (M) mit einem Bild auf dem ersten Objekttisch, wobei die Maske eine Vielzahl von isolierten Bereichen (110) umfasst, die mit dem Hintergrund kontrastieren und Merkmale zum Drucken bei der Herstellung einer Vorrichtung repräsentieren, wobei die isolierten Bereiche allgemein in einem Gitter angeordnet sind; Bereitstellen eines Substrats (W) mit einer strahlungsempfindlichen Schicht auf dem zweiten Objekttisch; und
Belichten des bestrahlten Bereichs der Maske (M) auf den Zielbereich des Substrats (W); **dadurch gekennzeichnet, dass**:

die Maske mit einer Vielzahl von Hilfsmerkmalen (151) versehen ist, die kleiner sind als die isolierten Bereiche (110) und so angeordnet sind, dass sie das Gitter symmetrischer machen.

**18.** Verfahren nach Anspruch 16, bei dem die Vorrichtung ein Speichergitter umfasst, insbesondere ein dynamisches Random-Access-Speichergitter.

**19.** Verfahren nach Anspruch 17 oder 18, bei dem die Hilfsmerkmale (151) eine größte Dimension aufweisen, die weniger als 50% der Wellenlänge des Projektionsstrahls beträgt, vorzugsweise im Bereich zwischen 30 und 40% der Wellenlänge des Projektionsstrahls.

**Revendications**

**1.** Masque pour utilisation dans un appareil de projection lithographique, le masque comprenant une pluralité de zones isolées (110) qui contrastent avec le fond et représentent des motifs à imprimer dans la fabrication d'un dispositif, lesdites zones isolées étant généralement disposées en une rangée ; **caractérisé par** :

une pluralité de motifs auxiliaires (151) plus petits que lesdites zones isolées et positionnés de manière à rendre plus symétrique ladite rangée.

**2.** Masque selon la revendication 1, dans lequel lesdites zones isolées (110) sont rangées en groupes définissant une cellule unitaire (120) et lesdits motifs auxiliaires sont positionnés de manière à rendre plus symétrique ladite cellule unitaire.

**3.** Masque selon la revendication 2, dans lequel lesdites zones isolées (110) sont positionnées à ou près de certains des points d'une ou plusieurs cellule(s) unitaire(s) régulière(s) (120) et lesdits motifs auxiliaires (151) sont positionnés en des points de la ou des cellule(s) unitaire(s) régulière(s) non occupés par lesdites zones isolées.

**4.** Masque selon la revendication 3, dans lequel lesdites zones isolées (A, B, C) sont positionnées à trois des angles d'une cellule unitaire rectangulaire et lesdits motifs auxiliaires (151) sont positionnés au quatrième angle.

**5.** Masque selon la revendication 1, 2, 3 ou 4, dans lequel lesdits motifs auxiliaires (151) sont positionnés de manière à réduire l'effet d'au moins une aberration occasionnelle dans le front d'onde produit par ledit modèle de masque quand il est illuminé par une radiation d'exposition dans ledit appareil de projection lithographique.

**6.** Masque selon l'une quelconque des revendications 1 à 5, dans lequel lesdits motifs auxiliaires (450) sont positionnés le long d'au moins une partie du bord de ladite rangée de manière à rendre les environs des motifs (410) à ou près du bord de la rangée plus semblables aux environs des motifs (420) à l'intérieur de la rangée.

**7.** Masque selon l'une quelconque des revendications précédentes, dans lequel lesdits motifs auxiliaires (151) sont positionnés de manière à réduire l'effet d'une aberration trionde et/ou comatique (1 onde) dans le front d'onde produit par ledit modèle de masque quand il est illuminé par une radiation d'exposition dans ledit appareil de projection lithographique.

**8.** Masque selon l'une quelconque des revendications précédentes, dans lequel lesdits motifs auxiliaires (151) ont le même contraste par rapport au fond dudit masque que lesdites zones isolées.

**9.** Masque selon l'une quelconque des revendications précédentes, dans lequel lesdits motifs isolés (110) sont plus transparents à la radiation d'exposition dudit appareil de projection lithographique que ledit fond.

**10.** Masque selon l'une quelconque des revendications 1 à 8, dans lequel lesdits motifs isolés (110) réfléchissent davantage la radiation d'exposition dudit appareil de projection lithographique que ledit fond.

**11.** Masque selon l'une quelconque des revendications 1 à 8, dans lequel lesdits motifs isolés (151) transmettent un changement de phase différent que ledit fond.

**12.** Masque selon l'une quelconque des revendications précédentes, dans lequel lesdits motifs auxiliaires (151) sont plus petits qu'une dimension critique dudit masque.

**13.** Masque selon la revendication 12, dans lequel lesdits motifs auxiliaires (151) sont plus petits qu'une limite de résolution dudit appareil de projection lithographique.

**14.** Procédé de fabrication d'un masque pour utilisation dans un appareil de projection lithographique, le procédé comprenant l'étape consistant à définir une pluralité de zones isolées (110) qui contrastent avec le fond et représentent des motifs à imprimer dans la fabrication d'un dispositif, lesdites zones isolées étant généralement disposées en une rangée ; **caractérisé par** l'étape ultérieure consistant à :

définir une pluralité de motifs auxiliaires (151) plus petits que lesdites zones isolées (110) et positionnés de manière à rendre plus symétriques ladite rangée.

**15.** Procédé selon la revendication 14, comprenant les étapes ultérieures consistant à :

déterminer des aberrations de front d'onde dans une image aérienne qui seraient produites dans ledit appareil de projection lithographique par le modèle desdites zones isolées (110) et
déterminer des positions, des formes et des dimensions pour ladite pluralité de motifs auxiliaires (151) de manière à réduire les aberrations dans ladite image aérienne.

**16.** Procédé selon la revendication 15, dans lequel on détermine lesdites positions pour ladite pluralité de motifs auxiliaires (151) de manière à réduire les aberrations trionde et/ou mono-onde (comatique).

**17.** Procédé de fabrication d'un dispositif utilisant un appareil de projection lithographique comprenant :

un système illuminateur (IL) pour fournir un faisceau projecteur de radiation ;

une première platine objet (MT) pourvue d'un premier porte-objet pour porter un masque ;

une seconde platine objet (WT) pourvue d'un second porte-objet pour porter un substrat ; et

un système de projection (PL) pour projeter une image d'une partie irradiée du masque sur une partie cible du substrat ; le procédé comprenant les étapes consistant à :

mettre en place un masque (M) portant le modèle à ladite première platine objet, ledit masque comprenant une pluralité de zones isolées (110) qui contrastent avec le fond et représentent des motifs à imprimer dans la fabrication d'un dispositif, lesdites zones isolées étant généralement disposées en une rangée ;

mettre en place un substrat (W) ayant une couche sensible aux radiations sur ladite seconde platine objet ; et

projeter l'image desdites parties irradiées du masque (M) sur lesdites parties cibles du substrat (W) ; **caractérisé en ce que** :

ledit masque est pourvu d'une pluralité de motifs auxiliaires (151) plus petits que lesdites zones isolées (110) et positionnés de manière à rendre plus symétrique ladite rangée.

18. Procédé selon la revendication 16, dans lequel ledit dispositif comprend une matrice mémoire, en particulier une matrice mémoire dynamique à accès aléatoire.

19. Procédé selon la revendication 17 ou 18, dans lequel lesdits motifs auxiliaires (151) ont une dimension maximale inférieure à 50 % de la longueur d'onde dudit faisceau de projection, de préférence dans un intervalle de 30 à 40 % de la longueur d'onde dudit faisceau de projection.

# Fig.1.

# Fig.2.

# Fig.3.

## Fig.4.

# Fig.5.

# Fig.6.

# Fig.7.

# Fig.8.

310

320

Fig.9.

Fig.10.

# Fig.11.